# EUROPEAN PATENT APPLICATION

(11) **EP 4 057 018 A1**
(43) Date of publication of application: **14.09.2022**
(21) Application number: 20891851.6
(22) Date of filing: 09.11.2020
(51) Int. Cl.: G01R 31/385, G01R 31/52

(54) **METHOD AND DEVICE FOR DETERMINING SHORT CIRCUIT IN BATTERY, AND ELECTRONIC DEVICE**

(30) Priority: 25.11.2019 CN 201911166178
(71) Applicant: GUANGDONG OPPO MOBILE TELECOMMUNICATIONS CORP., LTD., Dongguan, Guangdong 523860 (CN)
(72) Inventor: CHEN, Wei, Dongguan, Guangdong 523860 (CN)
(74) Representative: Manitz Finsterwald Patent- und Rechtsanwaltspartnerschaft mbB
(86) International application number: PCT/CN2020/127554
(87) International publication number: WO 2021/103995

(57) **Abstract**

A method for determining a short circuit in a battery (30, 133, 232) includes: separately acquiring a charge electric quantity charged in a preset voltage interval and a discharge electric quantity used in the preset voltage interval of the battery (30, 133, 232) (S210); and according to the charge electric quantity and the discharge electric quantity, determining whether the battery (30, 133, 232) has an internal short circuit (S220). According to the method, whether there is an internal short circuit in the battery (30, 133, 232) may effectively be determined according to the acquired battery (30, 133, 232) electric quantity charged in the preset voltage interval and discharge electric quantity used in the preset voltage interval of the battery (30, 133, 232).

## Description

The present application claims priority of Chinese Patent Application No. 201911166178.2, filed on November 25, 2019, in the title of "METHOD, DEVICE AND ELECTRONIC DEVICE FOR DETERMINING SHORT CIRCUIT WITHIN BATTERY", in China National Intellectual Property Administration, the entire contents of which are hereby incorporated by reference in their entireties.

### TECHNICAL FIELD

The present disclosure relates to the field of battery inspection, and in particular to a method, a device and an electronic device for determining an internal short circuit within a battery.

### BACKGROUND

A method for checking battery safety in the art may be achieved by monitoring a change of a battery voltage in real time to determine whether an internal short circuit is present in the battery. However, to perform the method, the change of the battery voltage may be monitored in real time to determine whether the battery has the internal short circuit. Scenarios that the method can be applied may be limited.

### SUMMARY OF THE DISCLOSURE

The present disclosure provides a method, a device and an electronic device for determining the short circuit within the battery to solve technical problems in the art.

In a first aspect, a method for determining an internal short circuit in a battery is provided. The method includes: obtaining an amount of power that is charged into the battery within a preset voltage interval and an amount of power that is discharged from the battery within the preset voltage interval; and determining whether the internal short circuit is present in the battery based on the amount of the charged power and the amount of the discharged power.

In a second aspect, a device for determining an internal short circuit in a battery is provided. The device includes: an obtaining unit, configured to obtain an amount of power that is charged into the battery within a preset voltage interval and an amount of power that is discharged from the battery within the preset voltage interval; and a determining unit, configured to determine whether the internal short circuit is present in the battery based on the amount of the charged power and the amount of the discharged power.

In a third aspect, an electronic device is provided. The electronic device includes a processor, configured to: obtain an amount of power that is charged into the battery within a preset voltage interval and an amount of power that is discharged from the battery within the preset voltage interval; and determine whether the internal short circuit is present in the battery based on the amount of the charged power and the amount of the discharged power.

In a fourth aspect, a computer-readable storage medium is provided and stores computer-executable instructions. The computer-executable instructions are configured to perform the method of the first aspect or any implementation of the method of the first aspect.

In a fifth aspect, a computer program product is provided and includes computer program instructions. The computer program instructions enable the computer to perform the method of the first aspect or any implementation of the method of the first aspect.

According to the method of determining the short circuit within the battery, an amount of power that is charged into the battery in a preset voltage interval and an amount of power that is discharged from the battery in the preset voltage interval may be obtained to effectively determine whether an internal short circuit is present in the battery. In addition, since the amount of the charged power and the amount of the discharged power can be obtained by a power meter, and the power meter is configured in the electronic device already, the technical problem of the method being applied to only limited scenarios may be solved.

### BRIEF DESCRIPTION OF THE DRAWINGS

FIG. 1 is a schematic diagram of a power detection apparatus according to an embodiment of the present disclosure.
FIG. 2 is a flow chart of a method for determining an internal short circuit in a battery according to an embodiment of the present disclosure.
FIG. 3 is a diagram of a voltage-capacity changing curve of a battery in a charging process and in a discharging process according to an embodiment of the present disclosure.
FIG. 4 is a schematic diagram of a device for determining an internal short circuit in a battery according to an embodiment of the present disclosure.
FIG. 5 is a schematic diagram of an electronic device according to an embodiment of the present disclosure.
FIG. 6 is a schematic diagram of a wired charging system according to an embodiment of the present disclosure.
FIG. 7 is a schematic diagram of a wired charging system according to another embodiment of the present disclosure.
FIG. 8 is a schematic diagram of a wireless charging system according to an embodiment of the present disclosure.
FIG. 9 is a schematic diagram of a wireless charging system according to another embodiment of the present disclosure.
FIG. 10 is a schematic diagram of a wireless charging system according to still another embodiment of the present disclosure.
FIG. 11 is a schematic diagram of a wireless charging system according to still another embodiment of the present disclosure.

### DETAILED DESCRIPTION

Technical solutions of the embodiments of the present disclosure will be clearly and completely described in the following by referring to the accompanying drawings. Apparently, the described embodiments are a part but not all of the embodiments of the present disclosure. All other embodiments obtained based on the embodiments in the present disclosure by an ordinary skilled person in the art without creative work shall fall within the scope of the present disclosure.

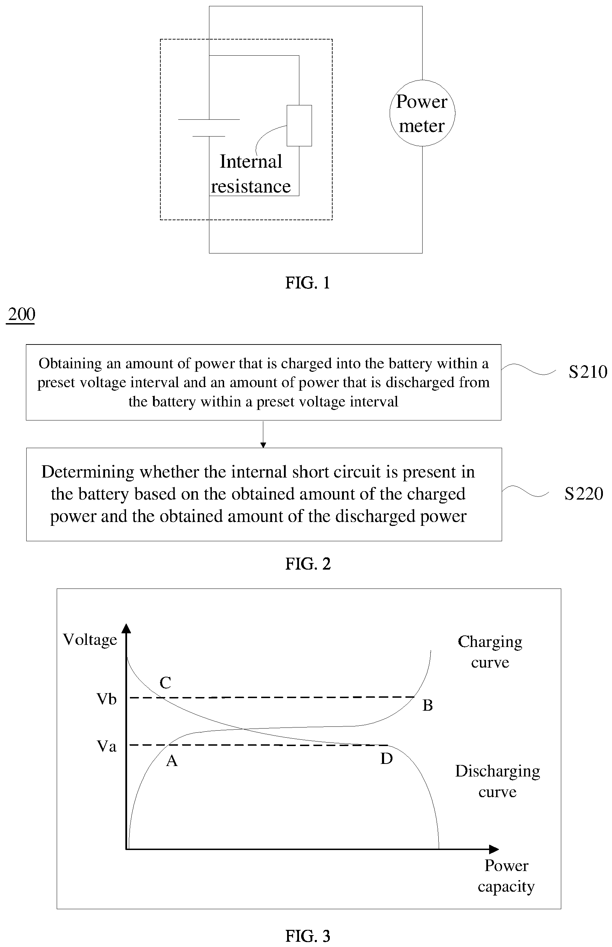

In order to understand the present disclosure more clearly, an apparatus and a method for detecting a power of a battery will be described in the following by referring to FIG. 1 to facilitate understanding of the present disclosure subsequently. However, it shall be understood that the following description is only for better understanding the present disclosure, and shall not provide any limitation to the present disclosure.

As shown in FIG. 1, a power detection apparatus is provided according to the embodiments of the present disclosure. While using the battery, a power meter may detect a current flowing through the battery, and an accumulated amount of power that is charged into the battery in the charging process and an accumulated amount of power that is discharged from the battery in the discharging process may be obtained based on a formula Q=I^{∗}t. The Q is the power charged into the battery in the charging process or the power used by the battery in the discharging process. The I is a charging current of the battery in the charging process or a discharging current of the battery in the discharging process. The t is a time duration of the charging process or a time duration of the discharging process.

According to the method in the embodiments of the present disclosure, presence of the internal short circuit in the battery can be effectively determined based on the obtained amount of the charged power and the obtained amount of the discharged power. Further, thermal runaway caused by continued use of the battery may be avoided.

The internal short circuit in the embodiments of the present disclosure may refer to a short circuit within the battery.

The battery in the embodiments of the present disclosure may be a battery in a terminal. The "terminal" may include, but is not limited to, an apparatus that is set up to connect via wireline connection (such as via a Public Switched Telephone Network (PSTN), a Digital Subscriber Line (DSL), a digital cable, a direct cable connection, and/or another data connection/network) and/or via, such as for a cellular network, a Wireless Local Area Network (WLAN), a digital video broadcasting handheld (DVB-H) network, a satellite network, an amplitude modulation-frequency modulation (AM-FM) broadcast transmitter, and/or a wireless interface of another communication terminal.

Examples of mobile terminals include, but are not limited to, satellite or cellular phones; personal communication system (PCS) terminals that can combine a cellular radio phone with data processing, faxing, and data communication capabilities; personal digital assistant (PDA) terminals that can include radio telephones, pagers, Internet/Intranet access, Web browsers, notepads, calendars and/or Global Positioning System (GPS) receivers; and conventional lap tops and/or handheld receivers or other electronic devices including radiotelephone transceivers. In some embodiments, a to-be-charged device may refer to a mobile terminal, which may be a device or a handheld terminal device, such as a mobile phone, a pad, and so on. In some embodiments, the to-be-charged device in the embodiments of the present disclosure may refer to a chip system, in which the battery of the device may or may not belong to the chip system.

In addition, the terminal may include other devices that have charging requirements, such as mobile phones, mobile powers (such as power banks, travel chargers, and so on), electric vehicles, laptops, drones, tablets, e-books, e-cigarettes, smart to-be-charged devices, and small electronics. The smart to-be-charged devices may include, for example, watches, bracelets, smart glasses, and sweeping robots. The small electronics may include, for example, wireless headphones, Bluetooth audios, electric toothbrushes and rechargeable wireless mice, and so on.

The method 200 for determining the internal short circuit in the battery according to the embodiment of the present disclosure will be described in detail below by referring to FIG. 2.

The method for determining the internal short circuit in the battery according to the present embodiment may be applied in a testing stage or performed while using the battery. The charging power and the charging voltage of the battery may be controlled when it is determined that the internal short circuit is present in the battery.

As shown in FIG. 2, the method 200 according to the embodiment of the present disclosure may include operations S210-S220.

In an operation S210, an amount of power that is charged into the battery within a preset voltage interval and an amount of power that is discharged from the battery within the preset voltage interval may be obtained.

The preset voltage interval in the present embodiment may be any voltage interval. For example, the voltage interval may be a voltage interval between a point A and a point B in FIG. 3. When a rated voltage of the battery is 4.4V, the preset voltage interval in the present embodiment may be 3V to 4V, or 3V to 4.4V, or 3.5V to 4V, which will not be limited by the present disclosure.

The amount of the charged power and the amount of the discharged power in the present embodiment may be obtained by a power meter. As mentioned in the above, the power meter may detect a current flowing through the battery. Therefore, the amount of the power that is charged into the battery while the battery is being charged and the amount of the power discharged from the battery while the battery is being used can be calculated based on a formula Q=I^{∗}t. The t may be a duration of the preset voltage interval of the battery while the battery is being charged or while the battery is discharging. That is, the t can be obtained by recording a duration of the battery voltage falling within the preset voltage interval while the battery is being charged and while the battery is discharging.

In an operation S220, presence of an internal short circuit in the battery is determined based on the amount of the charged power and the amount of the discharged power.

According to the method of determining the internal short circuit in the battery of the present embodiment, the amount of the power that is charged into the battery in the preset voltage interval and the amount of the power that is discharged from the battery in the preset voltage interval may be obtained to effectively determine whether the internal short circuit is present in the battery. In addition, since the amount of the charged power and the amount of the discharged power can be obtained by the power meter, and the power meter is configured in the electronic device already, the technical problem of the method being applied to only limited scenarios may be solved.

As illustrated in the above, the presence of the internal short circuit in the battery may be determined based on a difference between the amount of the charged power and the amount of the discharge power, which will be described in more detail below.

Alternatively, in some embodiments, the operation of determining the presence of the internal short circuit in the battery based on the difference between the amount of the charged power and the amount of the discharge power, includes following operations. The internal short circuit is determined to be present in the battery in response to the amount of the charged power being greater than the amount of the discharged power. The internal short circuit is determined to be not present in the battery in response to the amount of the charged power being equal to the amount of the discharged power.

Detailed description will be provided in the following by referring to FIG. 3 as an example. As shown in FIG. 3, FIG. 3 is a diagram of a voltage- power capacity changing curve of a battery in the charging process and in the discharging process according to an embodiment of the present disclosure.

In the present embodiment, in a process of charging the battery, when a power of the battery is increased from a point A to a point B, and a battery voltage is increased from a voltage Va to a voltage Vb, an amount of power charged into the battery within the voltage interval may be obtained based on a charging current and a time duration recorded by the power meter. For example, the amount of the power that is charged into the battery may be Q1. Similarly, in a process of discharging the battery, when the amount of the power of the battery is decreased from a point C to a point D, and the battery voltage is decreased from the voltage Vb to the voltage Va, an amount of power that is used within this voltage interval may be obtained based on a discharging current and a time duration recorded by the power meter. For example, the amount of the power that is discharged may be Q2. When Q1>Q2, it may be determined that the internal short circuit is not present in the battery.

In detail, when the battery is charged with a charging current of 1A for 10 minutes, and the battery voltage is increased from 3V to 4V, the amount of power that is charged into the battery within this voltage interval may be calculated as Q1=I^{∗}t=1A^{∗}600s=600C. Similarly, the battery is discharged with a discharging current of 1A, and time spent for discharging the battery voltage from 4V to 3V is recorded. When the time spent for discharging the battery voltage from 4V to 3V is 5 minutes, the amount of power that is used by the battery may be calculated as Q2==I^{∗}t=1A^{∗}300s=300C. Since the amount of the charged power Q1> the amount of the discharged power Q2, it may be determined that the internal short circuit is present in the battery. That is, the remaining 300C of power may be consumed by an internal resistance of the battery in a form of heat.

In detail, when the battery is charged with 1A current for 10 minutes, and the battery voltage is increased from 3V to 4V, the amount of the power that is charged into the battery within this voltage interval may be calculated as Q1=I^{∗}t=1A^{∗}600s=600C. Similarly, the battery is discharged with 1A current, and the time spent for discharging the battery voltage from 4V to 3V is recorded. When the time spent for discharging the battery voltage from 4V to 3V is 10 minutes, the amount of the power that is used by the battery may be calculated as Q2==I^{∗}t=1A^{∗}600s=600C. Since Q1=Q2, it may be determined that no internal short circuit is present in the battery. In other words, all of the power that is charged into the battery is consumed in a form of electric power, and no power is consumed by the internal resistance of the battery in the form of heat. Of course, the above may be an ideal situation, i.e., the battery does not have the internal resistance.

Alternatively, in some embodiments, the operation of determining the presence of the internal short circuit in the battery based on the amount of the charged power and the amount of the discharged power includes following operations. When time spent for charging the amount of the charged power into the battery is greater than time spent on using the discharged power, it may be determined that the internal short circuit is present in the battery. When time spent for charging the charged power into the battery is equal to time spent on using the discharged power, it may be determined that the internal short circuit is not present in the battery.

In the present embodiment, in the process of charging the battery, the battery is charged, the amount of power of the battery may be increased from the point A to the point B, and the battery voltage may be increased from the voltage Va to the voltage Vb. In the process of discharging the battery, the battery may be discharged, the amount of power of the battery may be decreased from the point C to the point D, and the battery voltage may be decreased from the voltage Vb to the voltage Va. In the above two processes, when the charging current and the discharging current are the same, and when time spent on charging the battery to allow the amount of power of the battery to increase from the point A to the point B is equal to time spent on discharging the battery to allow the amount of power of the battery to decrease from the point C to the point D, it may be determined that the internal short circuit is not present in the battery. When the charging current and the discharging current are the same, and when the time spent on charging the battery to allow the amount of power of the battery to increase from the point A to the point B is not equal to the time spent on discharging the battery to allow the amount of power of the battery to decrease from the point C to the point D, it may be determined that the internal short circuit is present in the battery.

It shall be understood that the above values are listed as an example only, and other values may be taken, which shall not limit the present disclosure.

As stated in the above, when the amount of the charged power is greater than the amount of the discharged power, it may be determined that the internal short circuit is present in the battery. When the amount of the charged power is equal to the amount of the discharged power, it may be determined that the internal short circuit is not present in the battery. Of course, the above description shows a case that the battery is in an ideal state, i.e., the battery does not have the internal resistance. However, practically, the battery does have the internal resistance. Especially after the battery is charged and discharged for a plurality of times, the internal resistance of the battery may increase. Therefore, another embodiment of the present disclosure will be described below.

Alternatively, in some embodiments, the operation of determining the presence of the internal short circuit in the battery based on the amount of the charged power and the amount of the discharged power includes following operations. When a difference between the amount of the charged power and the amount of the discharged power is greater than a first threshold, it may be determined that the internal short circuit is present in the battery. When the difference between the amount of the charged power and the amount of the discharged power is less than or equal to the first threshold, it may be determined that the internal short circuit is not present in the battery.

In the present embodiment, in the process of charging the battery, as shown in FIG. 3, the battery is charged, the amount of power of the battery may be increased from the point A to the point B, and the battery voltage is increased from the voltage Va to the voltage Vb. In this case, the power that is charged into the battery may be obtained based on the charging current and the time duration recorded by the power meter. For example, the amount of the charged power may be Q1. Similarly, in the process of discharging the battery, the battery is discharged, the amount of power of the battery may be decreased from the point B to the point A, and the battery voltage is increased from the voltage Vb to the voltage Va. In this case, the amount of the power that is used by the battery may be obtained based on the discharging current and the time duration recorded by the power meter. For example, the amount of the discharged power may be Q2. When a difference between the Q1 and the Q2 is greater than the first threshold, such as greater than 100 C, it may be determined that the internal short circuit is present in the battery. When the difference between the Q1 and the Q2 is less than or equal to the first threshold, such as less than or equal to 100 C, it may be determined the internal short circuit is not present in the battery.

In detail, when the battery is charged with 1A of current for 10 minutes, and when the battery voltage is increased from 3V to 4V, the amount of the power that is charged into the battery may be calculated as Q1=I^{∗}t=1A^{∗}600s=600C. Similarly, when the battery is discharged with 1A of current, time spent for discharging the battery to allow the battery voltage to decrease from 4V to 3V is recorded. When the time spent for discharging the battery to allow the battery voltage to decrease from 4V to 3V is 6 minutes, the amount of the power that is used by the battery may be calculated as Q2==I^{∗}t=1A^{∗}360s=360C. Since 600-360=240C>100C, it may be determined that the internal short circuit is present in the battery.

It shall be understood that, in the above-mentioned case, since the difference between the amount of power that is charged into the battery in the charging process and the amount of power that is discharged from the battery in the discharging process is greater than the first threshold, it may be determined that the internal short circuit is present in the battery. In the embodiment of the present disclosure, in the above-mentioned case, the difference between the amount of power that is charged into the battery in the charging process and the amount of power that is discharged from the battery in the discharging process is 240C. That is, 240C of power is consumed in the form of heat by the internal resistance of the battery. Therefore, in this case, it may be determined that the internal short circuit is present in the battery.

Similarly, when the battery is charged with 1A of current for 10 minutes, and when the battery voltage is increased from 3V to 4V, the amount of the power that is charged into the battery may be calculated as Q1=I^{∗}t=1A^{∗}600s=600C. Similarly, when the battery is discharged with 1A of current, the time spent for discharging the battery to allow the battery voltage to decrease from 4V to 3V is recorded. When the time spent for discharging the battery to allow the battery voltage to decrease from 4V to 3V is 9 minutes, the amount of the power that is used by the battery may be calculated as Q2==I^{∗}t=1A^{∗}540s=540C. Since 600-540=60C<100C, it may be determined that the internal short circuit is not present in the battery.

It shall be understood that, in the above-mentioned case, since the difference between the amount of power that is charged into the battery in the charging process and the amount of power that is discharged from the battery in the discharging process is less than the first threshold, it may be determined that the internal short circuit is not present in the battery. In the above-mentioned case, the difference between the amount of power that is charged into the battery in the charging process and the amount of power that is discharged from the battery in the discharging process is 60C. That is, 60C of power is consumed in the form of heat by the internal resistance of the battery. Therefore, in this case, it may be determined that the internal short circuit is not present in the battery.

It shall be understood that the above values are listed as an example only, and other values may be taken, which will not limit the present disclosure.

As stated in the above, the presence of the internal short circuit in the battery may be determined based on the amount of the charged power and the amount of the discharged power. In the following sections, further measures, which may be taken by a terminal device when the internal short circuit is determined to be present in the battery, will be described.

Alternatively, in some embodiments, the method 200 further includes following operations. When the internal short circuit is determined to be present in the battery, the terminal device controls a maximum amount of power that can be charged into the battery to be less than or equal to a second threshold. Alternatively, When the internal short circuit is determined to be present in the battery, the terminal device controls a maximum charging voltage of the battery to be less than or equal to a third threshold.

In an embodiment, when the internal short circuit is determined to be present in the battery, the maximum amount of power that can be charged into the battery may be controlled to be less than or equal to the second threshold in an instant charging process and in subsequent charging processes. For example, a rated power capacity of the battery is 5000 mAh, when it is determined that the internal short circuit is present in the battery while the battery is used for a first time, the maximum amount of power that can be charged into the battery may be controlled to be less than or equal to the second threshold, such as less than or equal to 9000C, in the process of charging the battery.

In the embodiment of the present disclosure, the rated power capacity of the battery is 5000mAh, that is, the amount of power of the battery is 18000C. In this case, in the process of charging the battery, when the amount of power of the battery reaches the second threshold, such as reaching 9000C, the charging process may be stopped. Alternatively, when the amount of power of the battery does not reach the second threshold, such as not reach 9000C, the charging process may be stopped. In this way, thermal runaway caused by continued charging of the battery may be prevented. Further, personal injuries or property damage caused by the thermal runaway may be prevented.

In another embodiment, when it is determined that the internal short circuit is present in the battery, the maximum charging voltage of the battery may be controlled to be less than or equal to the third threshold in the instant charging process and in subsequent charging processes. For example, the rated voltage of the battery is 4.4V. When the internal short circuit is determined to be present in the battery while the battery is being used for the first time, the maximum charging voltage of the battery may be controlled to be less than or equal to the third threshold, such as less than or equal to 3.8V, in the process of charging the battery.

In the embodiments of the present disclosure, the rated voltage of the battery is 4.4V. In this case, when the battery voltage reaches 3.8V in the process of charging the battery, the charging process may be stopped. Alternatively, when the battery voltage does not reach the third threshold, such as not reaching 3.8V, in the process of charging the battery, the charging process may be stopped. In this way, thermal runaway caused by continued charging of the battery may be prevented. Further, personal injuries or property damage caused by the thermal runaway may be prevented.

It shall be understood that the above values are listed as an example only, and other values may be taken, which will not limit the present disclosure.

Alternatively, in some embodiments, the method further includes following operations. When it is determined that the internal short circuit is present in the battery, the terminal device sends an instruction information to a power supply apparatus, the instruction information instructs the power supply apparatus to stop charging the battery or to charge the battery in a lower speed.

In the embodiment of the present disclosure, when the internal short circuit is determined to be present in the battery, in the instant charging process and in subsequent charging processes, a communication control circuit in the terminal device in the embodiment of the present disclosure may provide a charging status of the battery to the power supply apparatus, for example, the amount of power of the battery has reached or is about to reach the maximum amount of power that can be charged into the battery, and the battery voltage has reached or is about to reach the maximum charging voltage of the battery. At the same time, the communication control circuit may instruct the power supply apparatus to stop charging the battery or to charge the battery in a lower speed.

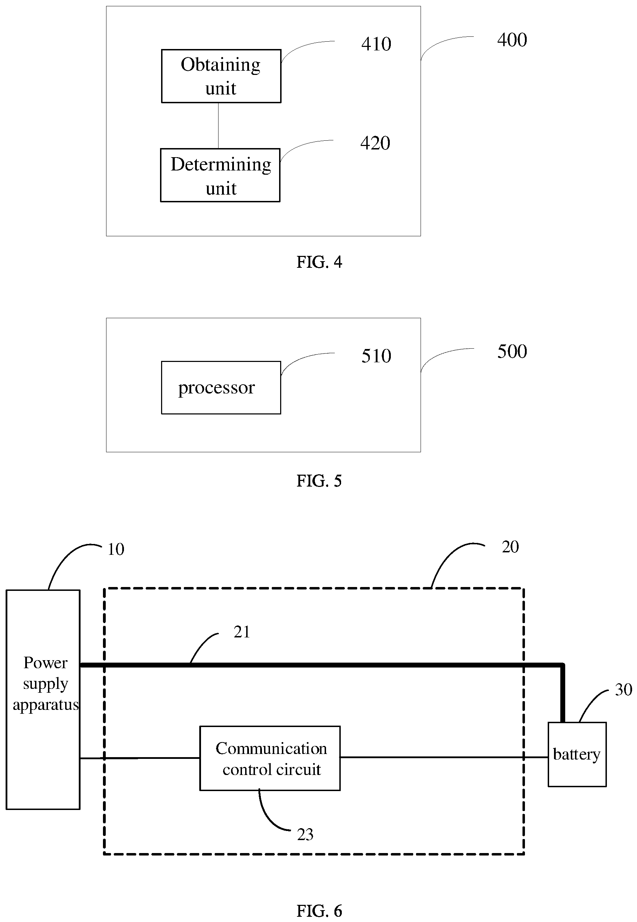

Method embodiments of the present disclosure are described in detail in the above by referring to FIGS. 1-3. Apparatus embodiments of the present disclosure will be described in detail below by referring to FIGS. 4-11. The apparatus embodiments correspond to the method embodiments. Therefore, any part that is not described in detail may be referred to previous method embodiments.

As shown in FIG. 4, a device 400 for determining the internal short circuit in the battery is provided according to an embodiment of the present disclosure. The device 400 may include an obtaining unit 410 and a determining unit 420.

The obtaining unit 410 is configured to obtain the amount of the power that is charged into the battery within the preset voltage interval and the amount of the power that is discharged from the battery within the preset voltage interval.

The determining unit 420 is configured to determine whether the internal short circuit is present in the battery based on the amount of the charged power and the amount of the discharged power.

Alternatively, in some embodiments, the determining unit 420 is further configured to: determine that the internal short circuit is present in the battery when the amount of the charge power is greater than the amount of the discharged power; and determine that the internal short circuit is not present in the battery when the amount of the charge power is equal to the amount of the discharged power.

Alternatively, in some embodiments, the determining unit 420 is further configured to: determine that the internal short circuit is present in the battery when the difference between the amount of the charged power and the amount of the discharged power is greater than the first threshold; and determine that the internal short circuit is not present in the battery when the difference between the amount of the charged power and the amount of the discharged power is less than or equal to the first threshold.

Alternatively, in some embodiments, the determining unit 420 is further configured to: determine that the internal short circuit is present in the battery when the time spent for charging the amount of the charged power into the battery is greater than the time spent for consuming the amount of the discharged power; and determine that the internal short circuit is not present in the battery when the time spent for charging the amount of the charged power into the battery is equal to the time spent for consuming the amount of the discharged power.

Alternatively, in some embodiments, the device 400 further includes a control unit. The control unit is configured to: control the maximum amount of power that can be charged into the battery to be less than or equal to the second threshold when the internal short circuit is determined to be present in the battery; or control the maximum charging voltage of the battery to be less than or equal to the third threshold when the internal short circuit is determined to be present in the battery.

Alternatively, in some embodiments, the device 400 further includes a transmitting unit. The transmitting unit is configured to: transmit the instruction information to the power supply apparatus when the internal short circuit is determined to be present in the battery. The instruction information instructs the power supply apparatus to stop charging the battery or to charge the battery in a lower speed.

As shown in FIG. 5, an electronic device 500 is provided in an embodiment of the present disclosure. The device 500 may include a processor 510.

The processor 510 is configured to: obtain the amount of the power that is charged into the battery within the preset voltage interval and the amount of the power that is discharged from the battery within the preset voltage interval; and determine whether the internal short circuit is present in the battery based on the amount of the charged power and the amount of the discharged power.

Alternatively, in some embodiments, the processor 510 is further configured to: determine that the internal short circuit is present in the battery when the amount of the charge power is greater than the amount of the discharged power; and determine that the internal short circuit is not present in the battery when the amount of the charge power is equal to the amount of the discharged power.

Alternatively, in some embodiments, the processor 510 is further configured to: determine that the internal short circuit is present in the battery when the difference between the amount of the charged power and the amount of the discharged power is greater than the first threshold; and determine that the internal short circuit is not present in the battery when the difference between the amount of the charged power and the amount of the discharged power is less than or equal to the first threshold.

Alternatively, in some embodiments, the processor 510 is further configured to: determine that the internal short circuit is present in the battery when the time spent for charging the charged power into the battery is longer than the time spent for consuming the discharged power; and determine that the internal short circuit is not present in the battery when the time spent for charging the charged power into the battery is equal to the time spent for consuming the discharged power.

Alternatively, in some embodiments, the processor 510 is further configured to: control the maximum amount of power that can be charged into the battery to be less than or equal to the second threshold when the internal short circuit is determined to be present in the battery; or control the maximum charging voltage of the battery to be less than or equal to the third threshold when the internal short circuit is determined to be present in the battery.

Alternatively, in some embodiments, the processor 510 is further configured to: transmit the instruction information from the terminal device to the power supply apparatus when the internal short circuit is determined to be present in the battery. The instruction information instructs the power supply apparatus to stop charging the battery or to charge the battery in a lower speed.

Embodiments of the present disclosure further provide a computer-readable storage medium that stores computer-executable instructions. The computer-executable instructions may be set to perform any one of the charging methods 200 described in the above.

Embodiments of the present disclosure further provides a computer program product. The computer program product includes a computer program that is stored on a computer readable storage medium.

The computer program includes program instructions. When the program instructions are executed by a computer, the program instructions enables the computer to perform any one of the charging methods 200 as described in the above.

Solutions of the embodiments of the present disclosure can be applied in a wired charging process or in a wireless charging process, which will not be limited by the present disclosure.

The wired charging process in which the embodiments of the present disclosure may be applied is described below by referring to FIGS. 6-7.

FIG. 6 is a schematic diagram of a charging system according to an embodiment of the present disclosure. The charging system includes a power supply device 10, a battery management circuit 20, and a battery 30. The battery management circuit 20 may be configured to manage the battery 30. In the embodiment of the present disclosure, the device 400 and an electronic device 500 for determining presence of the internal short circuit in the battery may include the battery management circuit 20 and the battery 30.

In an embodiment, the battery management circuit 20 may manage the charging process of the battery 30, such as selecting a charging channel, controlling the charging voltage and/or the charging current, and so on. In another embodiment, the battery management circuit 20 may manage a cell of the battery 30, such as balancing a voltage of the cell in the battery 30, and so on.

The battery management circuit 20 may include a first charging channel 21 and a communication control circuit 23.

The power supply apparatus 10 may be the power supply device as described above that has an adjustable output voltage. However, the present disclosure does not limit a type of power supply apparatus 20. For example, the power supply apparatus 20 may be a device dedicated for charging, such as an adapter and a mobile power (a power bank), or other devices capable of providing power and data services, such as a computer.

When the internal short circuit is determined to be present in the battery 30, in the instant charging process and in subsequent charging processes, the communication control circuit 23 in the present embodiment may control the process of providing the charging status of the battery 30 to the power supply apparatus 10, for example, the amount of power of the battery has reached or is about to reach the maximum amount of power that can be charged into the battery, and the battery voltage has reached or is about to reach the maximum charging voltage of the battery. At the same time, the communication control circuit 23 may instruct the power supply apparatus 10 to stop charging the battery 30 or to charge the battery 30 at a lower speed.

The battery management circuit provided in the embodiment of the present disclosure may directly charge the battery. In other words, the battery management circuit provided in the embodiment of the present disclosure is a battery management circuit that supports a direct charging architecture. In the direct charging architecture, a conversion circuit does not need to be configured on a direct charging channel, such that heat generated by the to-be-charged device in the charging process may be reduced.

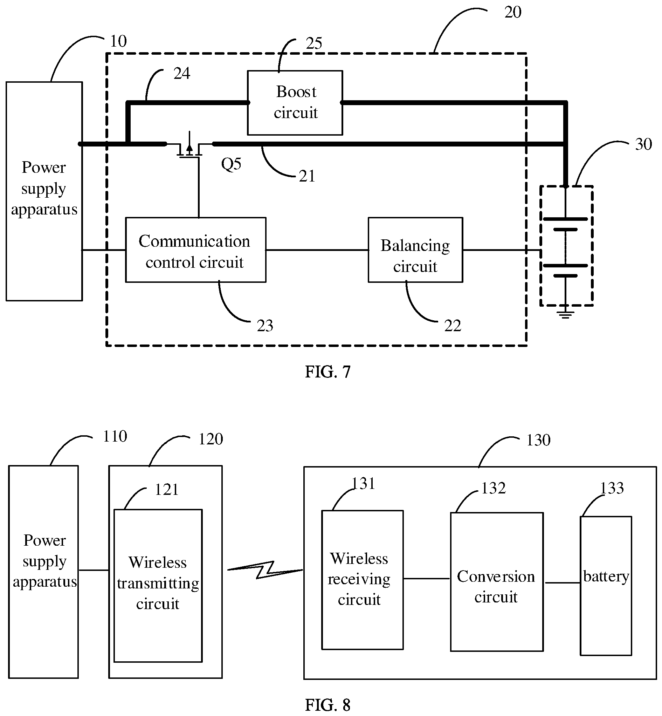

Alternatively, in some embodiments, as shown in FIG. 7, the battery management circuit 20 may further include a second charging channel 24. A boost circuit 25 may be configured on the second charging channel 24. In a process that the power supply apparatus 10 charges the battery 30 through the second charging channel 24, the boost circuit 25 may be configured to: receive an initial voltage provided by the power supply apparatus 10; increase the initial voltage to a target voltage; and charge the battery 30 based on the target voltage. The initial voltage is less than a total voltage of the battery 30, and the target voltage is greater than the total voltage of the battery 30. The communication control circuit 23 may further be configured to control switching between the first charging channel 21 and the second charging channel 24.

For the battery 30 that includes a plurality of cells, the battery management circuit 20 may further include a balancing circuit 22, as described in the above, the balancing circuit 22 may be configured to balance voltages of the plurality of cells in the process of charging the battery and/or the in the process of the battery being discharging.

The wireless charging process that the embodiments of the present disclosure may be applied will be described below by referring to FIGS. 8-11.

According to the conventional wireless charging technology, the power supply apparatus (such as an adapter) is connected to a wireless charging apparatus (such as a wireless charging base), an output power provided by the power supply apparatus may be transmitted through the wireless charging apparatus to the to-be-charged device wirelessly (such as electromagnetic waves) to charge the to-be-charged device. The to-be-charged device may be the electronic device as described above.

According to wireless charging principles, wireless charging methods may substantially include magnetic coupling (or electromagnetic induction), magnetic resonance, and radio waves. In the art, major wireless charging standards include the QI standard, the power matters alliance (PMA) standard, and the alliance for wireless power (A4WP). In the QI standard and the PMA standard, the magnetic coupling may be applied for wireless charging. In the A4WP standard, the magnetic resonance may be applied for wireless charging.

A wireless charging method according to an embodiment is described below by referring to FIG. 8.

As shown in FIG. 8, the wireless charging system includes a power supply apparatus 110, a transmitting apparatus 120 for transmitting a wireless charging signal, and a charging control apparatus 130. The transmitting apparatus 120 may be, such as a wireless charging base. The charging control apparatus 130 may refer to the device 400 or the electronic device 500 for determining the internal short circuit in the battery according to the embodiment of the present disclosure.

After the power supply apparatus 110 is connected to the transmitter apparatus 120, the output voltage and the output current of the power supply apparatus 110 may be transmitted to the transmitting apparatus 120.

The transmitting apparatus 120 may convert the output voltage and the output current of the power supply apparatus 110 into a wireless charging signal (such as an electromagnetic signal) and transmit the wireless charging signal through an internal wireless transmitting circuit 121. For example, the wireless transmitting circuit 121 may convert the output current of the power supply apparatus 110 into an alternating current, and convert the alternating current into the wireless charging signal through a transmitting coil or a transmitting antenna.

The charging control apparatus 130 may receive the wireless charging signal transmitted by the wireless transmitting circuit 121 through a wireless receiving circuit 131, and convert the wireless charging signal into an output voltage and an output current of the wireless receiving circuit 131. For example, the wireless receiving circuit 131 may convert the wireless charging signal transmitted by the wireless transmitting circuit 121 into the alternating current through the receiving coil or the receiving antenna, perform an rectification operation and/or a filtering operation on the alternating current, and convert the alternating current into the output voltage and the output current of the wireless receiving circuit 131.

When the output voltage of the wireless receiving circuit 131 is not suitable to be directly loaded to two ends of a battery 133, a constant voltage and/or a constant current control may be applied to the output voltage by the conversion circuit 132 within the charging control apparatus 130. In this way, a charging voltage and/or a charging current that is expected by the battery 133 within the charging control apparatus 130 may be obtained.

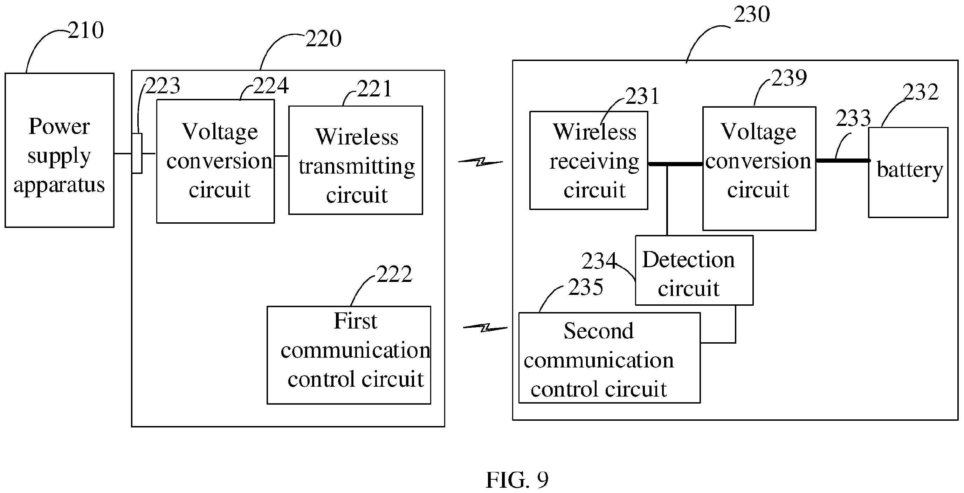

FIG. 9 is a schematic diagram of a wireless charging system according to another embodiment of the present disclosure. As shown in FIG. 9, the transmitting apparatus 220 for transmitting the wireless charging signal may further include a charging interface 223. The charging interface 223 may be configured to connect to an external power supply apparatus 210. The wireless transmitting circuit 221 may further be configured to generate the wireless charging signal based on the output voltage and output current of the power supply apparatus 210.

In a wireless charging process, a first communication control circuit 222 may extract an amount of power from the output power of the power supply apparatus 210 to adjust a transmitting power of the wireless transmitting circuit 221, such that the transmitting power of the wireless transmitting circuit 221 meets a charging demand of the battery. For example, the power supply apparatus 210 may directly output a relatively large fixed power (such as 40W), the first communication control circuit 222 may directly adjust the wireless transmitting circuit 221 to extract an amount of power from the fixed power provided by the power supply apparatus 210.

The present disclosure does not limit a type of power supply apparatus 210. For example, the power supply apparatus 210 may be an adapter, a power bank, a vehicle charger, a computer, and the like.

Alternatively, the first communication control circuit 222 adjusting the power of transmitting the wireless charging signal may refer that the first communication control circuit 222 adjusts the power of transmitting the wireless charging signal by adjusting an input voltage and/or an input current of the wireless transmitting circuit 221. For example, the first communication control circuit may increase the input voltage of the wireless transmitting circuit to increase the transmitting power of the wireless transmitting circuit.

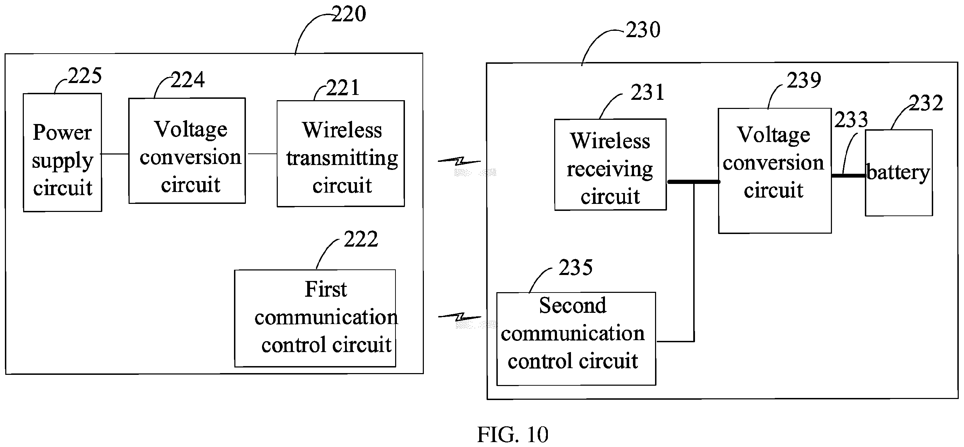

Alternatively, as shown in FIG. 10, the to-be-charged device 230 further includes a first charging channel 233. The output voltage and/or the output current of the wireless receiving circuit 231 may be provided to the battery 232 through the first charging channel 233 to charge the battery 232.

Alternatively, a voltage conversion circuit 239 may be configured on the first charging channel 233. An input end of the voltage conversion circuit 239 is electrically connected to an output end of the wireless receiving circuit 231 to perform the constant voltage and/or the constant current control on the output voltage of the wireless receiving circuit 231 to charge the battery 232. In this way, the output voltage and/or the output current of the voltage conversion circuit 239 matches the charging voltage and/or the charging current that is currently desired by the battery.

The present disclosure does not limit a manner in which the second communication control circuit 235 sends the instruction information to the first communication control circuit 222.

For example, the second communication control circuit 235 may periodically send the instruction information to the first communication control circuit 222. Alternatively, the second communication control circuit 235 may send the instruction information to the first communication control circuit 222 only when the voltage of the battery reaches a charging cutoff voltage, or when the charging current of the battery reaches a charging cutoff current.

Alternatively, when the internal short circuit is present in the battery 230, in the instant charging process and in subsequent charging processes, the second communication control circuit 235 in the present embodiment may control the operation of providing the charging status of the battery 230 to the first communication control circuit 222 in the power supply apparatus 210. For example, the amount of power in the battery has reached or is about to reach the maximum amount of power that can be charged into the battery, and the battery voltage has reached or is about to reach the maximum charging voltage of the battery. At the same time, the second communication control circuit 235 may instruct the power supply apparatus 210 to stop charging the battery 230 or to charge the battery 230 at a lower speed.

Alternatively, as shown in FIG. 9, an apparatus for receiving the wireless charging signal may further include a detection circuit 234. The detection circuit 234 may detect the voltage and/or the charging current of the battery 232. The second communication control circuit 235 may send the instruction message to the first communication control circuit 222 based on the voltage and/or the charging current of the battery 232 to instruct the first communication control circuit 222 to adjust the output voltage and the output current corresponding to the transmitting power of the wireless transmitting circuit 221.

It shall be understood that, in an embodiment of the present disclosure, the output voltage and/or the output current of the voltage conversion circuit 239 matching the charging voltage and/or the charging current that is currently desired by the battery may include following features. A voltage value and/or a current value of the direct current output from the first charging channel 232 may be equal to or substantially equal to but having a fluctuation within a preset range (such as 100 mV to 200 mV greater than or less than a voltage value, 0.001A to 0.005A greater than or less than a current value, and the like) around the charging voltage value and/or the charging current desired by the battery 232.

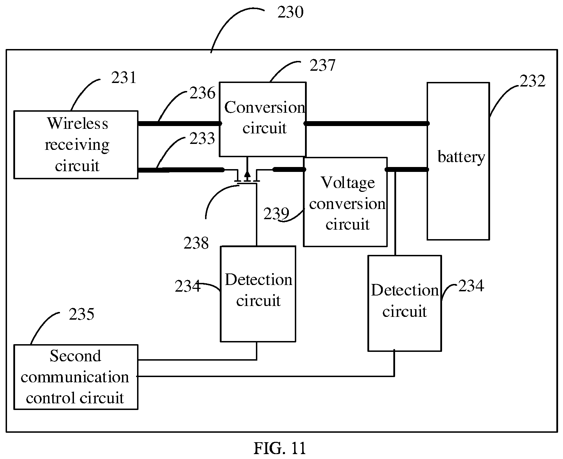

As shown in FIG. 11, in an embodiment of the present disclosure, the to-be-charged device 230 may further include a second charging channel 236. The second charging channel 236 may be a wire. A conversion circuit 237 may be configured on the second charging channel 236 to perform a voltage control on the direct current output from the wireless receiving circuit 231 to obtain an output voltage and an output current of the second charging channel 236 to charge the battery 232.

In an embodiment, the conversion circuit 237 may be configured in a buck circuit and output constant-current electrical energy and/or constant-voltage electrical energy. In other words, the conversion circuit 237 may be configured to provide the constant voltage and/or the constant current control for the process of charging the battery.

When the battery 232 is charged through the second charging channel 236, the wireless transmitting circuit 221 may take a constant transmitting power to transmit an electromagnetic signal. After the wireless receiving circuit 231 receives the electromagnetic signal, the conversion circuit 237 may process the electromagnetic signal into a voltage and a current that meet charging requirements of the battery 232, and the obtained voltage and the obtained current may be input to the battery 232, such that the battery 232 is charged. It shall be understood that, in some embodiments, the constant transmitting power may not indicate that the transmitting power remains exactly the same, but the transmitting power may vary within a certain range. For example, the transmitting power may fluctuate with 0.5W greater than or less than 7.5W.

In the embodiments of the present disclosure, a function of the second communication control circuit can be implemented by an application processor of the to-be-charged device 230, thereby saving hardware costs. Alternatively, the function of the second communication control circuit can be implemented by an independent control chip. Implementation by the independent control chip may improve reliability of the control.

Alternatively, in the present disclosure, the wireless receiving circuit 231 and the voltage conversion circuit 239 may be integrated into one wireless charging chip. In this way, integration of the to-be-charged device may be improved, and the implementation of the to-be-charged device may be simplified. For example, functions of a conventional wireless charging chip may be expanded to allow the conventional wireless charging chip to support charging management functions.

The entirety or a part of the above embodiments may be implemented by software, hardware, firmware, or any other combination. When the embodiments are implemented by software, the implementation may be in a form of a computer program product. The computer program product includes one or more computer instructions. While loading and executing the computer program instructions on a computer, the entirety or a part of the process or functions as described in the embodiments of the present disclosure may be achieved. The computer may be a general purpose computer, a dedicated computer, a computer network, or other programmable device. The computer instructions may be stored in a computer-readable storage medium or transmitted from one computer-readable storage medium to another computer-readable storage medium. For example, the computer instructions may be transmitted from one web site, one computer, one server, or one data center to another web site, another computer, another server, or another data center via wired means (such as a coaxial cable, a fiber optic, a digital subscriber line (DSL)) or wireless means (such as infrared, wireless, microwave, and the like). The computer-readable storage medium may be any available medium that a computer has access or a data storage device such as a server, a data center, and the like that includes one or more available integrated media. The available media may be magnetic media (such as a floppy disk, a hard disk, a magnetic tape), optical media (such as a Digital Video Disc (DVD)), or semiconductor media (such as a Solid State Disk (SSD)), and the like.

Any ordinary skilled person in the art shall realize that units and algorithmic operations of the various examples described by referring to the embodiments herein are capable of being implemented in electronic hardware, or a combination of computer software and electronic hardware. Particular application and design constraints of the technical solutions may determine whether these functions are performed in hardware or software. The skilled person may perform different methods to implement the described functions for each particular application, but such implementations shall not be considered as being excluded from the scope of the present disclosure.

In several embodiments of the present disclosure, it shall be understood that the disclosed systems, devices and methods, can be implemented in other ways. For example, the device embodiments described above are merely schematic. For example, division of units is only a logical functional division, and the units can be practically divided in another way. For example, a plurality of units or components can be combined or can be integrated into another system. Alternatively, some features can be omitted or not implemented. On another point, the mutual coupling or direct coupling or communicative connection shown or discussed in the above can be an indirect coupling or communicative connection through some interfaces, and an indirect coupling or communicative connection between devices or units, which can be electrical, mechanical or in other forms.

In the present disclosure, although the terms "first", "second", and the like may be used in the present disclosure to describe various devices, the devices shall not be limited by these terms. These terms are used only to distinguish one device from another. For example, without changing the meaning of the description, a first device may be called a second device, and similarly, a second device may be called a first device, as long as all "first devices" are consistently renamed, and all "second devices" are consistently renamed. Both the first device and the second device are devices, but may not be a same device.

Units illustrated as separate components may or may not be physically separated. Components displayed as units may or may not be physical units. That is, the units may locate in one place or may be distributed to a plurality of network units. Some or all of these units can be selected according to practical needs to achieve the purpose of the solutions of the embodiments.

In addition, each functional unit in various embodiments of the present disclosure may be integrated in one single processing unit, or each unit may be physically present separately, or two or more units may be integrated in one single unit.

The above description is only specific implementation of the present disclosure, but the scope of the present disclosure is not limited thereto. Variations or substitutions that is raised by any ordinary skilled person in the art shall be included in the scope disclosed of the present disclosure. Therefore, the scope of the present disclosure shall be subject to the scope of the appended claims.

## Claims

1. A method for determining an internal short circuit in a battery, comprising:
obtaining an amount of power that is charged into the battery within a preset voltage interval and an amount of power that is discharged from the battery within the preset voltage interval; and
determining whether the internal short circuit is present in the battery based on the amount of the charged power and the amount of the discharged power.

2. The method according to claim 1, wherein the determining whether the internal short circuit is present in the battery based on the amount of the charged power and the amount of the discharged power, comprises:
determining that the internal short circuit is present in the battery in response to the amount of the charged power being greater than the amount of the discharged power; and
determining that the internal short circuit is not present in the battery in response to the amount of the charged power being equal to the amount of the discharged power.

3. The method according to claim 1, wherein the determining whether the internal short circuit is present in the battery based on the amount of the charged power and the amount of the discharged power, comprises:
determining that the internal short circuit is present in the battery in response to a difference between the amount of the charged power and the amount of the discharged power being greater than a first threshold; and
determining that the internal short circuit is not present in the battery in response to the difference between the amount of the charged power and the amount of the discharged power being less than or equal to the first threshold.

4. The method according to claim 1, wherein the determining whether the internal short circuit is present in the battery based on the amount of the charged power and the amount of the discharged power, comprises:
determining that the internal short circuit is present in the battery in response to time spent on charging the amount of the charged power into the battery being greater than time spent on consuming the amount of the discharged power; and
determining that the internal short circuit is not present in the battery in response to time spent on charging the amount of the charged power into the battery being equal to time spent on consuming the amount of the discharged power.

5. The method according to any one of claims 1 to 4, further comprising:
controlling, by a terminal device, a maximum amount of power that is capable of being charged into the battery to be less than or equal to a second threshold in response to determining that the internal short circuit is present in the battery; or
controlling, by a terminal device, a maximum charging voltage of the battery to be less than or equal to a third threshold in response to determining that the internal short circuit is present in the battery.

6. The method according to any one of claims 1 to 4, further comprising:
sending, by a terminal device, an instruction information to a power supply apparatus in response to determining that the internal short circuit is present in the battery, wherein the instruction information is configured to instruct the power supply apparatus to stop charging the battery or to charge the battery in a lower speed.

7. A device for determining an internal short circuit in a battery, comprising:
an obtaining unit, configured to obtain an amount of power that is charged into the battery within a preset voltage interval and an amount of power that is discharged from the battery within the preset voltage interval; and
a determining unit, configured to determine whether the internal short circuit is present in the battery based on the amount of the charged power and the amount of the discharged power.

8. The device according to claim 7, wherein the determining unit is further configured to:
determine that the internal short circuit is present in the battery in response to the amount of the charged power being greater than the amount of the discharged power; and
determine that the internal short circuit is not present in the battery in response to the amount of the charged power being equal to the amount of the discharged power.

9. The device according to claim 7, wherein the determining unit is further configured to:
determine that the internal short circuit is present in the battery in response to a difference between the amount of the charged power and the amount of the discharged power being greater than a first threshold; and
determine that the internal short circuit is not present in the battery in response to the difference between the amount of the charged power and the amount of the discharged power being less than or equal to the first threshold.

10. The device according to claim 7, wherein the determining unit is further configured to:
determine that the internal short circuit is present in the battery in response to time spent on charging the amount of the charged power into the battery being greater than time spent on consuming the amount of the discharged power; and
determine that the internal short circuit is not present in the battery in response to time spent on charging the amount of the charged power into the battery being equal to time spent on consuming the amount of the discharged power.

11. The device according to any one of claims 7 to 10, further comprising a control unit, configured to:
control a maximum amount of power that is capable of being charged into the battery to be less than or equal to a second threshold in response to determining that the internal short circuit is present in the battery; or
control a maximum charging voltage of the battery to be less than or equal to a third threshold in response to determining that the internal short circuit is present in the battery.

12. The device according to any one of claims 7 to 10, further comprising a transmitting unit, configured to transmit an instruction information to a power supply apparatus in response to determining that the internal short circuit is present in the battery, wherein the instruction information is configured to instruct the power supply apparatus to stop charging the battery or to charge the battery in a lower speed.

13. An electronic device, comprising: a processor, configured to:
obtain an amount of power that is charged into the battery within a preset voltage interval and an amount of power that is discharged from the battery within the preset voltage interval; and
determine whether the internal short circuit is present in the battery based on the amount of the charged power and the amount of the discharged power.

14. The electronic device according to claim 13, wherein the processor is further configured to:
determine that the internal short circuit is present in the battery in response to the amount of the charged power being greater than the amount of the discharged power; and
determine that the internal short circuit is not present in the battery in response to the amount of the charged power being equal to the amount of the discharged power.

15. The electronic device according to claim 13, wherein the processor is further configured to:
determine that the internal short circuit is present in the battery in response to a difference between the amount of the charged power and the amount of the discharged power being greater than a first threshold; and
determine that the internal short circuit is not present in the battery in response to the difference between the amount of the charged power and the amount of the discharged power being less than or equal to the first threshold.

16. The electronic device according to claim 13, wherein the processor is further configured to:
determine that the internal short circuit is present in the battery in response to time spent on charging the amount of the charged power into the battery being greater than time spent on consuming the amount of the discharged power; and
determine that the internal short circuit is not present in the battery in response to time spent on charging the amount of the charged power into the battery being equal to time spent on consuming the amount of the discharged power.

17. The electronic device according to any one of claims 13 to 16, wherein the processor is further configured to:
control a maximum amount of power that is capable of being charged into the battery to be less than or equal to a second threshold in response to determining that the internal short circuit is present in the battery; or
control a maximum charging voltage of the battery to be less than or equal to a third threshold in response to determining that the internal short circuit is present in the battery.

18. The electronic device according to any one of claims 13 to 16, wherein the processor is further configured to:
transmit an instruction information from a terminal device to a power supply apparatus in response to determining that the internal short circuit is present in the battery, wherein the instruction information is configured to instruct the power supply apparatus to stop charging the battery or to charge the battery in a lower speed.

19. A computer-readable storage medium, storing computer-executable instructions, wherein the computer-executable instructions are configured to perform the method according to any one of claims 1 to 6.
